# EUROPEAN PATENT APPLICATION

(11) **EP 2 990 376 A1**
(43) Date of publication of application: **02.03.2016**
(21) Application number: 15180898.7
(22) Date of filing: 13.08.2015
(51) Int. Cl.: B81B 7/00

(54) **MEMS DEVICES AND METHOD OF MANUFACTURING**

(30) Priority: 25.08.2014 US 201414467234
(71) Applicant: Rosemount Aerospace Inc., Burnsville MN 55306-4898 (US)
(72) Inventor: POTASEK, David P., South Windsor, CT 06074 (US)
(74) Representative: Iceton, Greg James

(57) **Abstract**

A MEMS sensor includes a sensor die (101) configured to generate a sensor signal and a pedestal layer (103) disposed on the sensor die (101). The pedestal layer (103) includes a channel (107) defined therein about a pedestal (105) of the pedestal layer (103). The pedestal (105) is configured to be mounted to a housing. A method for manufacturing MEMS sensors can include disposing a pedestal layer (103) on a sensor layer, wherein the sensor layer defines a plurality of sensor dies (101) to be cut therefrom. The method further includes defining a respective channel (107) in the pedestal layer (103) for each sensor die (101), thereby creating a pedestal (105) for each sensor die (101).

## Description

### BACKGROUND

### 1. Field

The present disclosure relates to micro electromechanical systems (MEMS), more particularly to MEMS devices used as sensors.

### 2. Description of Related Art

MEMS sensors can be bulk manufactured as wafers which are divided through cutting the wafer. Stress isolation in MEMS sensors can be achieved by attaching one or more pedestals to each sensor die to mount the sensor die to the housing of the MEMS device. Physical stresses acting upon the MEMS sensors are translated to the pedestal without transferring the stresses to the sensor die. Presently, each pedestal is manually placed on each die defined on the wafer which adds cost and processing time. Also, once each pedestal is attached, the wafer can no longer be processed using standard wafer handling tooling. Instead, custom fixtures with recesses for the pedestals are needed for further processing. Additionally, die spacing is increased to accommodate the specialized tooling, thereby reducing the amount of sensors that can fit on a wafer. The die spacing is a limiting factor on cost of production.

Such conventional methods and systems have generally been considered satisfactory for their intended purpose. However, there is still a need in the art for improved MEMS sensors and methods to manufacture MEMS sensors in bulk. The present disclosure provides a solution for this need.

### SUMMARY

In at least one aspect of this disclosure, a MEMS sensor includes a sensor die configured to generate a sensor signal and a pedestal layer disposed on the sensor die. The pedestal layer includes a channel defined therein about a pedestal of the pedestal layer. The pedestal is configured to be mounted to a housing.

The channel can define the pedestal in a cylindrical shape. It is also contemplated that the channel can define the pedestal in a rectangular shape, or in any other suitable shape. The channel can have a depth over half as deep as the pedestal layer is thick. The channel can have a depth less than the pedestal layer is thick.

The pedestal layer can include a remainder portion defined outside the channel having a thickness substantially equal to or longer than that of the pedestal.

The pedestal can include a fluid port defined therein in fluid communication with a sensor fluid port of the sensor die. The pedestal can have an aspect ratio wherein the depth of the pedestal is greater than the span of the pedestal in a direction perpendicular to the depth.

The pedestal layer can include at least one of a semi-conductor, conductor, or insulator material. The sensor die and the pedestal layer can be the same layer made from a single material or combination thereof.

A method for manufacturing MEMS sensors can include disposing a pedestal layer on a sensor layer, wherein the sensor layer defines a plurality of sensor dies to be cut therefrom. The method further includes defining a respective channel in the pedestal layer for each sensor die, thereby creating a pedestal for each sensor die.

Defining the channel can include chemically etching the respective channel into pedestal layer for each sensor die. In other embodiments, defining the channel can include machining the channel into the pedestal wafer.

The method can further include defining a fluid port within at least one of the pedestals. Defining the channel can further includes defining a remainder portion defined outside the channel having a thickness substantially equal to or longer than that of the pedestal.

These and other features of the systems and methods of the subject disclosure will become more readily apparent to those skilled in the art from the following detailed description taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, embodiments thereof will be described by way of example only and in detail herein below with reference to certain figures, wherein:
Fig. 1 is a schematic cross-sectional elevation view of an embodiment of a MEMS sensor wafer in accordance with this disclosure, showing pedestals defined in a pedestal layer thereof and including a remainder portion having a thickness about the same as the pedestals; and
Fig. 2 a schematic cross-sectional elevation view of another embodiment of a MEMS sensor wafer in accordance with this disclosure, showing pedestals defined in a pedestal layer thereof with a remainder portion having a thickness that is less than the thickness of the pedestals.

### DETAILED DESCRIPTION

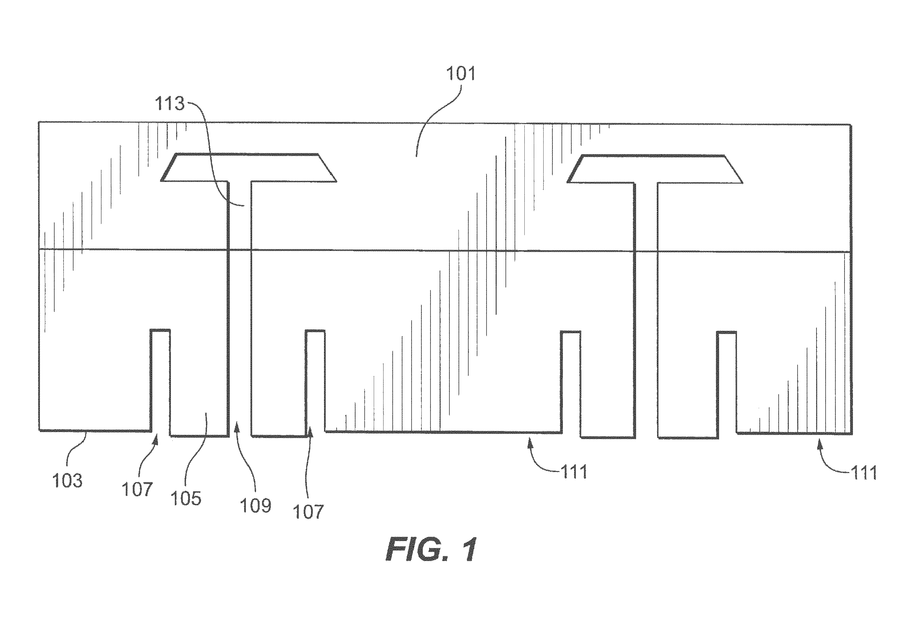

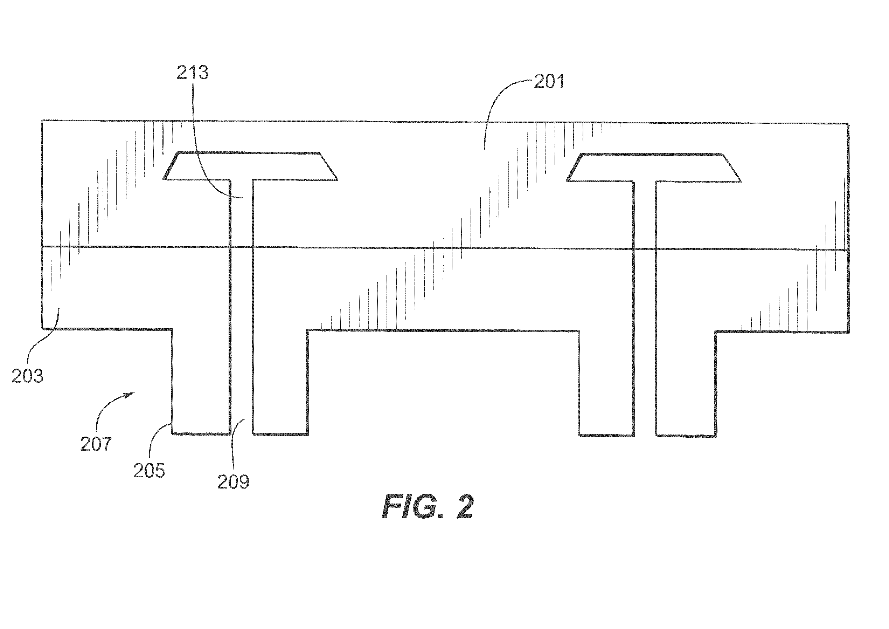

Reference will now be made to the drawings wherein like reference numerals identify similar structural features or aspects of the subject disclosure. For purposes of explanation and illustration, and not limitation, an illustrative view of an embodiment of a MEMS sensor wafer in accordance with the disclosure is shown in Fig. 1 and is designated generally by reference character 100. Another embodiment of a MEMS sensor wafer is shown in Fig. 2. The systems and methods described herein can allow bulk manufacture of MEMS sensors more efficiently.

In at least one aspect of this disclosure, a MEMS sensor (e.g., half of MEMS sensor wafer 100 as shown) includes a sensor die 101 (shown in a layer during manufacture) configured to generate a sensor signal and a pedestal layer 103 disposed on the sensor die 101. The pedestal layer 103 includes a channel 107 defined therein about a pedestal 105 of the pedestal layer 103. The pedestal 105 is configured to be mounted to a housing (not shown) such that stresses imparted to the housing are isolated to the pedestal 105 of the MEMS sensor.

The channel 107 can define the pedestal 105 in a cylindrical shape. In some embodiments, the channel 107 can define the pedestal in a rectangular shape. Any other suitable shape is contemplated herein. The width of the channels 107 can be any suitable width and can be adjusted to allow for process considerations or clearance to increase the tolerance in attaching a die.

The channel 107 can have a depth over half as deep as the pedestal layer 103 is thick (e.g., 50% of layer thickness, 90% of layer thickness). In some embodiments, the channel 107 can have a depth less than the pedestal layer 103 is thick. Any other suitable depth for the channel 107 is contemplated herein. For example, a predetermined aspect ratio of the pedestal 105 can be created depending on how wide and deep the channel 107 is defined in the pedestal layer 103. In embodiments, the pedestal 105 can include an aspect ratio such that the depth or thickness of the pedestal 105 is greater than the span of the pedestal 105 in a direction perpendicular to the depth. The relative dimensions can be balanced with the desire to make a robust structure that isn't fragile.

In embodiments, the pedestal 105 can include a fluid port 109 defined therein configured to be in fluid communication with a sensor fluid port 113 of the sensor die 101. This can allow fluid communication with the sensor die 101 for embodiments used as pressure sensors or any other suitable use.

The pedestal layer 103 and/or the sensor die 101 can include at least one of a semi-conductor, conductor, or insulator material. Any suitable material is contemplated herein. While the pedestal layer 103 and the sensor die 101 are shown as two separate layers, in some embodiments, the sensor die 101 and the pedestal layer 103 can be the same layer made from a single material or combination thereof.

As shown in Fig. 1, the pedestal layer 103 can include a remainder portion 111 defined outside the channel 107 having a thickness substantially equal to or longer than that of the pedestal 105. Alternatively, as shown in Fig. 2, a MEMS sensor wafer 200 can include a sensor die 201 pedestal 205 defined by a wide channel 207 in a pedestal layer 203 such that there is no remainder portion or where the remainder portion is not as thick as the pedestal 205.

Similar to the embodiment of Fig. 1 as described above, the pedestal 205 can include a fluid port 209 defined therethrough. The sensor die 201 can include a sensor fluid port 213 in fluid communication with the fluid port 209.

The above describe embodiments can be bulk fabricated at a faster rate since individual placement of each pedestal 105, 205 is no longer needed. Moreover, a remainder portion 111 as shown in Fig. 1 further allows for faster bulk fabrication of MEMS devices since the MEMS sensor wafer 100 can be processed without requiring different wafer processing tools or holding devices due to a uniform thickness in the layers before and after forming the channels 107. As a result, pedestals 105 and sensor die 101 can be placed closer together since no holding devices are necessary. In some embodiments, over twice as many sensors per wafer can be realized.

A method for bulk manufacture of MEMS sensors can include disposing a pedestal layer 103 on a sensor die layer, wherein the sensor die layer defines a plurality of sensor dies 101 to be cut therefrom. The method further includes defining a channel 107 in the pedestal layer 103 for each sensor die 101, thereby creating a pedestal 105 for each sensor die 101.

Defining the channel 107 can include chemically etching the respective channel 107 into pedestal layer 103 for each sensor die 101. In other embodiments, defining the channel 107 can include machining the channel 107 into the pedestal layer 103.

The method can further include defining a fluid port 109 within at least one of the pedestals 105. Defining the channel 107 can further include defining a remainder portion 111 defined outside the channel 107 having a thickness substantially equal to or longer than that of the pedestal 105.

The methods and systems of the present disclosure, as described above and shown in the drawings, provide for faster and more efficient MEMS device fabrication. While the apparatus and methods of the subject disclosure have been shown and described with reference to embodiments, those skilled in the art will readily appreciate that changes and/or modifications may be made thereto without departing from the scope of the subject disclosure.

## Claims

1. A MEMS sensor, comprising:
a sensor die (101) configured to generate a sensor signal; and
a pedestal layer (103) disposed on the sensor die, the pedestal layer including a channel (107) defined therein about a pedestal (105) of the pedestal layer (103), wherein the pedestal (105) is configured to be mounted to a housing.

2. The sensor of claim 1, wherein the channel (107) defines the pedestal (105) in a cylindrical shape.

3. The sensor of claim 1, wherein the channel (107) defines the pedestal (105) in a rectangular shape.

4. The sensor of claim 1, wherein the pedestal layer (103) includes a remainder portion defined outside the channel (107) having a thickness substantially equal to or longer than that of the pedestal (105).

5. The sensor of claim 1, wherein the channel (107) has a depth over half as deep as the pedestal layer (103) is thick.

6. The sensor of claim 1, wherein the channel (107) has a depth less than the pedestal layer (103) is thick.

7. The sensor of claim 1, wherein the pedestal (105) includes a fluid port (109) defined therein in fluid communication with a sensor fluid port (113) of the sensor die (101).

8. The sensor of claim 1, wherein the pedestal (105) includes an aspect ratio wherein the depth of the pedestal (105) is greater than the span of the pedestal (105) in a direction perpendicular to the depth.

9. The sensor of claim 1, wherein the pedestal layer (103) includes at least one of semi-conductor, conductor, or insulator material.

10. The sensor of claim 1, wherein the sensor die (101) and the pedestal layer (103) are the same layer made from a single material or combination thereof.

11. A method for manufacturing MEMS sensors, comprising:
disposing a pedestal layer (103) on a sensor layer, wherein the sensor layer defines a plurality of sensor dies (101) to be cut therefrom; and
defining a channel (107) in the pedestal layer (103) for each sensor die (101), thereby creating a pedestal (105) for each sensor die (101).

12. The method of claim 11, wherein defining the channel (107) includes chemically etching the respective channel (107) into pedestal layer (103) for each sensor die (101).

13. The method of claim 11, wherein defining the channel (107) includes machining the channel (107) into the pedestal wafer.

14. The method of claim 11, further comprising defining a fluid port (109) within at least one of the pedestals (105).

15. The method of claim 11, wherein defining the channel (107) further includes defining a remainder portion defined outside the channel (107) having a thickness substantially equal to or longer than that of the pedestal (105).
